# EUROPÄISCHE PATENTSCHRIFT

(11) **EP 1 655 616 B1**
(45) Veröffentlichungstag und Bekanntmachung des Hinweises auf die Patenterteilung: **09.01.2008**
(21) Anmeldenummer: 05023833.6
(22) Anmeldetag: 02.11.2005
(51) Int. Cl.: G01R 33/3815

(54) **NMR-Spektrometer mit Refrigeratorkühlung**
Refrigerator-cooled NMR spectrometer
Spectromètre à RMN avec refroidissement par réfrigérateur

(30) Priorität: 09.11.2004 DE 102004053973
(43) Veröffentlichungstag der Anmeldung: 10.05.2006
(73) Patentinhaber: Bruker BioSpin AG, 8117 Fällanden (CH)
(72) Erfinder: Triebe, René, 8051 Zürich (CH); Marek, Daniel, 5103 Möriken AG (CH); Schett, Oskar, 8610 Uster (CH); Baumann, Daniel Guy, Rumlikon 8332 Russikon ZH (CH)
(74) Vertreter: Kohler Schmid Möbus

(56) Entgegenhaltungen:
- EP-A- 0 878 718
- WO-A-03/023433
- US-A- 4 796 433
- PATENT ABSTRACTS OF JAPAN Bd. 2003, Nr. 12, 5. Dezember 2003 (2003-12-05) & JP 2004 219361 A (JEOL LTD), 5. August 2004 (2004-08-05)

## Beschreibung

Die Erfindung betrifft ein NMR-Spektrometer mit einem im Heliumtank eines Kryostaten angeordneten NMR-Magnetsystem und mit einem in einer Raumtemperaturbohrung des Kryostaten angeordneten NMR-Probenkopf, der einen gekühlten HF-Resonator zum Empfang von NMR-Signalen aus einer zu untersuchenden Probe und einen gekühlten Vorverstärker enthält, wobei der NMR-Probenkopf durch einen gemeinsamen mehrstufigen, Kompressor-betriebenen Refrigerator gekühlt wird, wobei der Refrigerator einen Kaltkopf und mehrere Wärmetauscher auf unterschiedlichen Temperaturniveaus umfasst, wobei der Refrigerator im räumlichen Abstand zum Kryostaten in einem separaten, evakuierten und wärmeisolierten Gehäuse angeordnet ist und mindestens ein Kühlmittelkreislauf mit durch eine Transferleitung thermisch isolierten Kühlmittelleitungen zwischen dem die Wärmetauscher enthaltenen Gehäuse und dem NMR-Probenkopf vorgesehen ist.

Eine derartige Vorrichtung ist aus US 5,889,456 bekannt.

Der NMR-Probenkopf eines NMR-Spektrometers befindet sich zusammen mit einer Messvorrichtung in der Bohrung eines Magnetkryostaten. In diesem Magnetkryostaten ist eine supraleitende Spule, die zur Erzeugung des für NMR-Messungen notwendigen Magnetfelds dient, untergebracht. Sowohl der NMR-Probenkopf als auch der Magnetkryostat müssen im Betrieb auf sehr kleinen Temperaturen gehalten werden. Die durch Wärmeleitung und Wärmestrahlung entstehenden Wärmeverluste stellen daher ein Problem dar.

Die Kühlung der Kryoprobenköpfe, zur kryogenen Kühlung des HF-Resonators und des Vorverstärkers sowie die Kühlung der supraleitenden NMR-Magnete, zur kryogenen Kühlung des Kryostaten und damit die Realisation einer Null-Verdampfungsrate für LN₂ wie auch für LHe (LN₂ = flüssiger Stickstoff, LHe = flüssiges Helium), sind somit auf dem Gebiet der NMR zwei wichtige Anwendungsbereiche von Kryo-Kühlsystemen.

Dazu stehen heute diverse käufliche Systeme zur Verfügung, die von verschiedenen Firmen angeboten werden. Die Firma JASTEC (Japan) [1] liefert ein Kühlsystem zur Kühlung des LN₂-Bereiches eines Kryostaten für supraleitende Magnetsysteme bis 400 MHz. Es enthält ein vibrationsarmes Pulse-Tube-Kühlaggregat, dessen maximale Kühlleistung jedoch kleiner ist als die der bekannten GM-Kühlaggregate (GM = Gifford-McMahon). Eine Null-Verdampfungsrate für LN₂ wird deshalb nur für NMR-Magnetsystem bis 400 MHz und nicht höher erreicht.

Die Firma NIHON THERMAL (Japan) [2] liefert ein Kühlsystem zur Kühlung des LN₂-Bereiches eines Kryostaten für supraleitende Magnete bis 600 MHz. Es enthält ein leistungsstarkes GM-Aggregat, das zwar stärkere Vibrationen verglichen mit dem von JASTEC erzeugt, anderseits aber eine Null-Verdampfungsrate für LN₂ bei 600 MHz-Magnetsystemen erlaubt.

Von der Firma OXFORD INSTRUMENTS SUPERCONDUCTIVITY (GB) [3] sind supraleitende NMR-Magnete mit einem Kühlsystem zur Kühlung des LN₂- wie auch des LHe-Bereiches des Kryostaten bekannt. Das Kühlsystem benutzt ein vibrationsarmes Pulse-Tube-Kühlaggregat, das direkt auf dem Kryostaten befestigt wird und eine Null-Verdampfungsrate sowohl für LN₂ wie auch für LHe erreicht.

Die Bruker BioSpin AG [4] und die Firma VARIAN (USA) [5] vertreiben je ein Kühlsystem, genannt "CryoPlatform" (Bruker BioSpin) und "Cryo Bay" (Varian), zur kryogenen Kühlung von HF-Resonatoren. Diese beiden Kühlsysteme enthalten ein GM-Kühlaggregat und verwenden kaltes He-Gas als Transport- und Kühlmittel.

Aus US 5,889,456 ist eine Vorrichtung bekannt, die einen Refrigerator zum Kühlen des NMR-Probenkopfs umfasst. Zur Übertragung der vom Refrigerator erzeugten Kühlleistung dienen Wärmetauscher und eine Transferleitung vom Refrigerator zum NMR-Probenkopf. Die Beschickung des NMR-Probenkopfes mit Kältemittel erfolgt durch Pumpen oder Kompressoren über die Transferleitungen. Die gekühlten Bauteile des Probenkopfs befinden sich üblicherweise auf Temperaturen von 10-60 Kelvin. Als Refrigerator kommt beispielsweise ein Gifford-MacMahon-Kühler (GM) oder ein Pulsrohr-Kühler (PT) zum Einsatz.

Ein Großteil der NMR-Magnetsysteme ohne aktive Kryokühlung besitzen Haltezeiten von über einem halben Jahr für das LHe, für das LN₂ hingegen nur von ca. zwei bis drei Wochen. Die kurze Haltezeit für LN₂ ist rein konstruktiv bedingt und gilt, solange zur thermischen Abschirmung des LN₂-Tankes ein nicht unverhältnismäßig großer Aufwand getrieben wird.

Der LN₂-Verlust liegt in der Größenordnung von 10-20 Watt bei ca. 77 K, was problemlos mit einem kleinen aktiven Kühlaggregat kompensiert werden könnte. Aber auch kleine, leistungsschwache Aggregate brauchen diverse Grundeinheiten wie z.B. Kompressoren und sind deshalb nicht billig. Der Kostenaufwand, um nur das eine Ziel zu erreichen, nämlich die LN₂-Verluste zu reduzieren oder vollständig zu kompensieren, kann deshalb in vielen Fällen zu hoch werden.

Aufgabe der Erfindung ist es daher, ein NMR-Spektrometer vorzuschlagen, bei dem ohne großen Kostenaufwand die Haltezeit von LN₂ an die des LHe angeglichen werden kann, um somit den Service-Aufwand beim Nachfüllen der kryogenen Flüssigkeiten zu reduzieren.

Diese Aufgabe wird erfindungsgemäß dadurch gelöst, dass zusätzliche Kühlmittelleitungen zu einem im Kryostaten angeordneten, den Heliumtank umgebenden Stickstofftank oder Strahlungsschild vorgesehen sind und der Refrigerator auch den Stickstofftank bzw. den Strahlungsschild kühlt.

Die Kühlvorrichtung zur Kühlung des NMR- Probenkopfes kann so dimensioniert werden, dass sie praktisch ohne zusätzlichen Kostenaufwand einen Überschuss an Kühlleistung bei ca. 34 K zum Kompensieren der LN₂-Verluste abgeben kann. Dabei wird ein Teil des Heliumgases, der eine Temperatur von ca. 34 K besitzt, nicht nur zur Kühlung des Vorverstärkers verwendet, sondern wird über eine weitere Transferleitung zu einem Wärmetauscher geführt, der in engem Kontakt mit dem verdampften N₂-Gas des LN₂-Tankes steht und dieses Gas teilweise oder vollständig zum Rekondensieren bringt. Der LN₂-Verbrauch kann somit enorm reduziert werden, so dass man z.B. nur alle 7 Monate den LHe- und LN₂-Tank gleichzeitig nachfüllen kann, und nicht alle zwei bis drei Wochen einen Nachfüllvorgang infolge der LN₂-Verluste durchführen muss.

Das Erstaunliche an dieser Idee ist die Einfachheit, mit der das Kühlen des LN₂₋Tankes, gelöst werden kann, und die Möglichkeit, dies kostengünstig zu realisieren. Aus der Einfachheit dieser Lösung ergibt sich ein weiterer Vorteil, indem die benötigten Konstruktionsteile auch als Retrofit-Einheiten ausgeführt werden können. Dadurch lassen sich bereits im Feld arbeitende NMR-Spektrometer nachträglich mit einer kostengünstigen LN₂-Kühlung ausrüsten.

Eine besonders einfache Ausführungsform des erfindungsgemäßen NMR-Spektrometers sieht vor, dass der Refrigerator nur den Stickstofftank bzw. den Strahlungsschild und nicht den Heliumtank im Kryostaten kühlt.

Bei einer bevorzugte Ausführungsform des vorliegenden NMR-Spektrometers besitzen die Kühlleitungen, die zum HF-Resonator, zum Vorverstärker und zum NMR-Magnetsystem führen, einen gemeinsamen thermisch isolierten Abschnitt innerhalb einer Transferleitung, der mindestens 50%, vorzugsweise etwa 90%, der Gesamtlänge der Transferleitungen umfasst. Hierdurch können Temperaturverluste beim Transfer der Kältemittel zu den zu kühlenden Objekten verringert werden.

Eine besonders bevorzugte Ausführungsform der Erfindung sieht vor, dass innerhalb des gemeinsamen thermisch isolierten Abschnittes die Kühlleitungen, die sich auf dem niedrigsten Energieniveau befinden, von mindestens einem Strahlungsschild auf einem höheren Energieniveau thermisch abgeschirmt werden. Die Kühlleitungen auf dem niedrigsten Energieniveau sind so einer verringerten Temperaturdifferenz ausgesetzt, was die Energieverluste und die Anforderung an die Isolierung des Leitungsabschnitts verringert.

In einer bevorzugten Ausführungsform weisen die Transferleitungen schwingungsdämpfende Bauteile zur Entkopplung von Refrigerator und NMR-Probenkopf beziehungsweise von Refrigerator und Kryostat auf. Die Güte der NMR-Messungen wird hierdurch verbessert.

Vorteilhafterweise ist zwischen dem Gehäuse und dem Kryostaten ein Kühlkreislauf vorgesehen, dessen Rücklauf sich auf einem Temperaturniveau von etwa 77K befindet. Ein derartiger Kühlkreislauf ist insbesondere zur Kühlung des Strahlungsschildes beziehungsweise des Stickstofftankes geeignet.

Darüber hinaus erweist es sich als vorteilhaft, wenn zwischen dem Gehäuse und dem NMR-Probenkopf zwei Kühlkreisläufe vorgesehen sind, von denen ein Kühlkreislauf eine Rücklauftemperatur von etwa 77K besitzt und vorzugsweise eine Vorverstärkerelektronik im NMR-Probenkopf kühlt.

Besonders vorteilhaft ist es, wenn zwischen dem Gehäuse, dem Kryostaten und dem NMR-Probenkopf ein gemeinsamer Kühlkreislauf vorgesehen ist, dessen Rücklauftemperatur bei etwa 77K liegt und der im Probenkopf vorzugsweise eine Vorverstärkerelektronik und im Kryostaten einen Stickstofftank oder einen Strahlungsschild kühlt. Dies ermöglicht eine besonders effektive Nutzung der Kühlleistung des Refrigerators.

Bei einer speziellen Ausführungsform werden die Kühlkreisläufe, deren Rücklauftemperatur bei etwa 77K liegt, mit gasförmigem Helium als Kältemittel betrieben.

Eine weitere Ausführungsform des erfindungsgemäßen NMR-Spektrometers sieht vor, dass einer der Kühlkreisläufe, die sich zwischen dem Gehäuse und dem NMR-Probenkopf befinden, eine Rücklauftemperatur von etwa 15K besitzt und mit gasförmigem Helium als Kühlmittel betrieben wird.

Bei einer besonders bevorzugten Ausführungsform des erfindungsgemäßen NMR-Spektrometers weist der gemeinsame Refrigerator mindestens einen Stufentauscher auf, an dem mindestens ein Kältemittel entlang geführt wird, so dass dieses Kältemittel auf eine definierte Temperatur vorgekühlt wird. Auf diese Weise kann auf einen der Wärmetauscher verzichtet werden. Zusätzlich ergibt sich die Möglichkeit die Temperatur des Kältemittels durch Wahl der Länge der Kontaktfläche der Transferleitung mit dem Regenerator individuell anzupassen.

Bei dem gemeinsamen Refrigerator handelt es sich vorzugsweise um einen Gifford-McMahon-Kühler oder einen Pulsrohrkühler. Speziell bei Verwendung eines Pulsrohrkühlers wird das Anbringen der Transferleitungen an das fest stehende Regeneratorrohr und somit der Temperaturaustausch erheblich vereinfacht.

Des Weiteren kann es vorteilhaft sein, wenn der Kompressor des Refrigerators zusätzlich mindestens einen der Kühlkreisläufe antreibt. Es wird somit kein zusätzlicher Kompressor benötigt.

Besonders vorteilhaft ist es, wenn der einen Stickstofftank oder einen Strahlungsschild kühlende Kühlkreislauf ein Ventil zur Regelung des Kühlmittelflusses und einen Wärmetauscher im thermischen Kontakt mit dem Stickstofftank beziehungsweise Strahlungsschild aufweist.

Eine spezielle Ausführungsform des erfindungsgemäßen NMR-Spektrometers sieht vor, dass die Kühlkreisläufe einen Heliumkreislauf mit mindestens einer Verzweigung im Vor- und und/oder Rücklauf bilden.

Weitere Vorteile der Erfindung ergeben sich aus der Beschreibung und den Zeichnungen. Die gezeigten und beschriebenen Ausführungsformen sind nicht als abschließende Aufzählung zu verstehen, sondern haben vielmehr beispielhaften Charakter für die Schilderung der Erfindung. Es zeigen:
- Fig. 1: eine Kühlvorrichtung gemäß dem Stand der Technik;
- Fig. 2: eine erfindungsgemäße Kühlvorrichtung mit einem zusätzlichen Kühlkreislauf zur Kühlung eines LN₂-Tanks;
- Fig. 3: eine erfindungsgemäße Kühlvorrichtung mit einem zusätzlichen Kühlkreislauf zur Kühlung eines Strahlungsschildes; und
- Fig. 4: eine erfindungsgemäße Kühlvorrichtung mit einer T-förmigen Transferleitung;

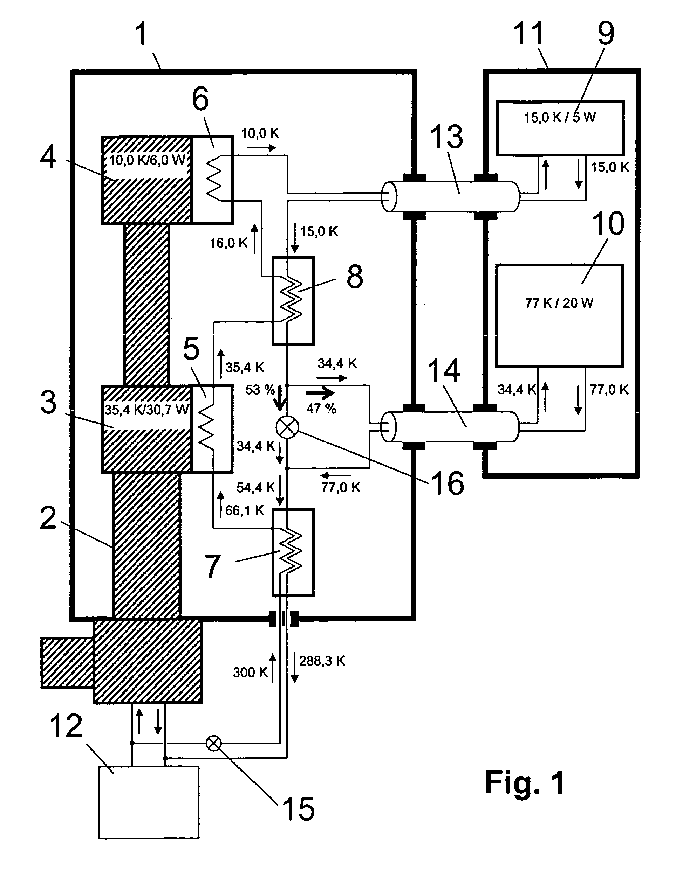

**Fig. 1** zeigt ein eine Kühlvorrichtung nach dem Stand der Technik mit einem evakuierten und wärmeisolierten Gehäuse **1,** in dem ein Refrigerator **2** mit einer ersten Kältestufe **3** und einer zweiten Kältestufe **4,** sowie Stufentauscher **5, 6** beziehungsweise Gegenstromtauscher **7, 8** untergebracht sind. Die Kühlvorrichtung dient der Kühlung eines HF-Resonators **9** und eines Vorverstärkers **10,** die beide Teile eines NMR-Probenkopfes **11** sind. Eine ähnlich Variante ist in US 5,889,456 beschrieben, mit dem Unterschied jedoch, dass das Heliumgas des geschlossenen Gaskreislaufes hier nicht mit einer separaten Umwälzpumpe umgewälzt wird, sondern mit dem Heliumkompressor **12** des Refrigerators 2 (ähnlich dem US-Patent 5,508,613).

Für den Transport der Kühlleistung wird Heliumgas verwendet, das in einem oder mehreren geschlossenen Kreisläufen fließt. Das Gehäuse 1 und der NMR-Probenkopf 11 werden über Transferleitungen **13, 14** miteinander verbunden. Auf diese Weise wird der Heliumgas-Kühlkreislauf zum Kühlen des HF-Resonators 9 und des Vorverstärkers 10 geschlossen. Ebenso wie das Gehäuse 1, sind auch der NMR- Probenkopf 11 und die beiden Transferleitungen 13, 14 evakuiert, um thermische Verluste infolge Wärmeleitung über die Luft zu vermeiden. Der Refrigerator 2, der die Kälteleistung zum Kühlen des HF-Resonators 9 und des Vorverstärkers 10 liefert, ist über Gasleitungen mit dem Kompressor 12 verbunden. Die ersten Kältestufe 3 des Refrigerators 2 befindet sich auf etwa 35,4 K, die zweiten Kältestufe 4 auf etwa 10 K. Beide Kältestufen 3, 4 besitzen thermische Anzapfungsflächen, die als Kältequellen dienen, und an die diverse Einzelteile angeschlossen und gekühlt werden können. Solche Einzelteile sind die Stufentauscher 5, 6, die an die erste 3 bzw. zweite Kältestufe 4 des Refrigerators 2 angeschlossen sind.

Der Kompressor 12 wälzt das Heliumgas des geschlossenen Kühlkreislaufs um. Der Kühlmittelfluss des Kühlkreislaufes wird über ein Ventil **15** eingestellt. Das Heliumgas tritt mit ca. Zimmertemperatur (300 K) vom Kompressor 12 in das Gehäuse 1 ein und wird zuerst mit Hilfe des ersten Gegenstromtauschers 7 auf 66,1 K und dann im Stufentauscher 5 der ersten Kältestufe 3 des Refrigerators 2 auf 35,4 K vorgekühlt, bevor es zum zweiten Gegenstromtauscher 8 gelangt. Dort wird das Heliumgas auf 16 K und im anschließenden Stufentauscher 6 der zweiten Kältestufe 4 auf die Endtemperatur von 10 K hinunter gekühlt. Dieses kalte Gas wird über die Transferleitung 13 dem HF-Resonator 9 zugeführt, wodurch letzterer auf 15 K abgekühlt wird. Anschließend gelangt das auf 15 K aufgewärmte Gas wieder über die Transferleitung 13 in das Gehäuse 1 und zum Gegenstromtauscher 8. Nach dem Gegenstromtauscher 8 wird ein Teil des 34,4 K kalten Gases (ca. 53%) über den Gegenstromtauscher 7 zurück zum Kompressor 12 geführt. Der andere Teil des 34,4 K kalten Gases (ca. 47%) wird über die Transferleitung 14 dem Vorverstärker 10 zugeführt, wodurch dieser auf 77 K abgekühlt wird. Anschließend gelangt das auf 77 K aufgewärmte Gas wieder über die Transferleitung 14 in das Gehäuse 1 und über den Gegenstromtauscher 7 zum Kompressor 12. Der Kühlmittelfluss durch den Vorverstärker 10 wird mit einem

Ventil **16** eingestellt.

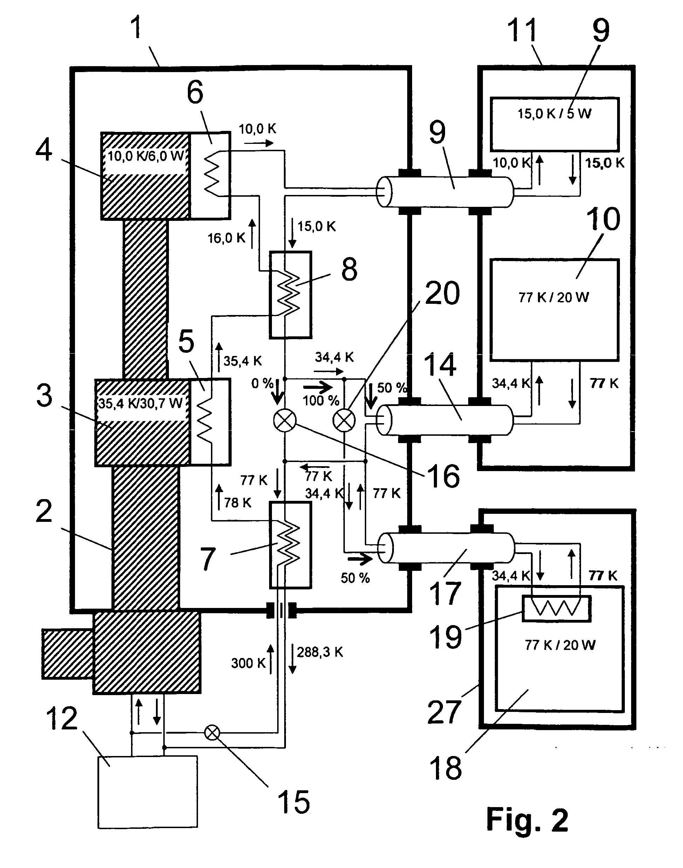

**Fig. 2** zeigt eine schematische Darstellung einer Ausführungsform eines erfindungsgemäßen NMR-Spektrometers mit einem zusätzlichen Kühlkreislauf, bei dem das kalte Heliumgas über eine zusätzliche Transferleitung **17** zu einem LN₂₋Tank **18** eines NMR-Magnetsystems **27** geführt wird und dort mit Hilfe eines Wärmetauschers **19** das verdampfte Stickstoffgas teilweise oder vollständig zum Rekondensieren bringt. Der Teil des Heliumgases, der eine Temperatur von ca. 34 K besitzt, wird dabei nicht nur zur Kühlung des Vorverstärkers 10 verwendet, sondern ein Teil davon wird über die weitere Transferleitung 17 zu dem Wärmetauscher 19 geführt wird, der in engem Kontakt mit dem verdampften N₂₋Gas des LN₂-Tankes 18 steht und dieses Gas teilweise oder vollständig zum Rekondensieren bringt. Die Verteilung des Heliumgases zwischen dem Vorverstärker 10 und dem LN₂-Tank 18 kann, wie in Fig. 2 gezeigt, so erfolgen, dass 50% dem Vorverstärker 10 und 50% dem LN₂-Tank 18 zugeteilt wird. Die Ventile 16 und 20 dienen der Einstellung der beiden He-Massenflüsse, nämlich dem zum Vorverstärker 10 und dem zum LN₂-Tank 18 des NMR-Magnetsystems 27. Auf diese Weise kann lediglich durch das Anbringen einer zusätzlichen Transferleitung 17 und einem zusätzlichen Ventil 20 der LN₂-Tank 18 des Magnetsystems 27 eines NMR-Spektrometers kühlen. Es werden kein zusätzlicher Refrigerator und Kompressor benötigt.

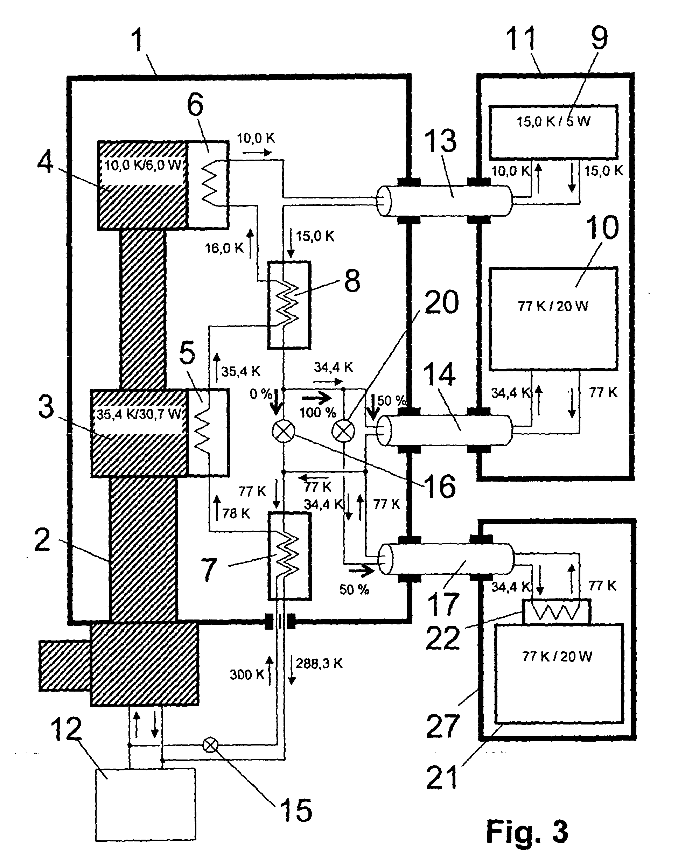

Neben der in Fig. 2 gezeigten Ausführungsform, bei der durch die zusätzlich angebrachte Transferleitung 17 der LN₂-Tank 18 des NMR-Magnetsystems 27 gekühlt wird, besteht auch die Möglichkeit einen Strahlungsschild **21,** das um einen LHe-Tank angebracht ist, durch die Transferleitung 17 zu kühlen. Diese Ausführungsform des erfindungsgemäßen NMR-Spektrometers ist in **Fig. 3** gezeigt. In diesem Fall wird das kalte Heliumgas über die Transferleitung 17 einem Wärmetauscher **22** zugeführt, der in engem thermischen Kontakt mit dem Strahlungsschild 21 steht. Durch den im Wärmetauscher 22 stattfindenden Wärmetransfer wird der Strahlungsschild 21 abkühlt.

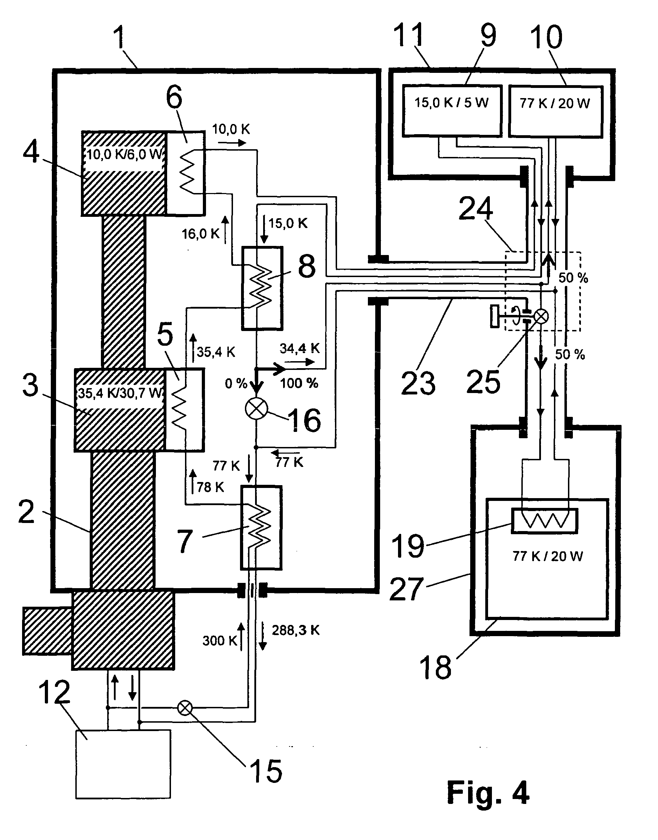

Fig. 4 zeigt eine Ausführungsform der erfindungsgemäßen Vorrichtung mit einer T-förmigen Transferleitung **23.** Die Verzweigung der Kühlkreisläufe findet in diesem Fall nicht innerhalb des Gehäuses 1, sondern im Verzweigungsbereich **24** der T-förmigen Transferleitung 23 statt. Die Funktion des Ventils 20 übernimmt hier das Ventil **25,** das sich im Verzweigungsbereich 24 der T-förmigen Transferleitung 23 befindet. Die drei einzelnen Transferleitungen 13, 14, 17 der zuvor beschriebenen Ausführungsformen sind hier in einer einzigen T-förmigen Transferleitung 23 mit einem Verzweigungsbereich 24 zusammengefasst. Die T-förmige Transferleitung 23 besitzt zudem einen Abschnitt **26,** der bei dem Gehäuse 1 beginnt und beim Verzweigungsbereich 24 endet, wobei in diesem Abschnitt 26 die Kühlleitungen zum Vorverstärker 10 und die zum NMR-Magnetsystem 27 jeweils zu einer einzigen Zu- und Rückleitung zusammengefasst sind, und wobei zudem diese Zu- und Rückleitung sowie die Zu- und Rückleitung zum HF-Resonator 9 im selben thermisch isolierten Raum der Transferleitung 23 liegen und parallel zueinander geführt werden. Damit sind die Voraussetzungen geschaffen, dass die Kühlleitungen, die sich auf dem niedrigsten Energieniveau befinden (= Kühlleitungen zum HF-Resonator 9) thermisch abgeschirmt werden können, und zwar durch einen Strahlungsschild, der auf einem höheren Energieniveau liegt und in engem thermischen Kontakt mit den Kühlleitungen zum Vorverstärker 10 und NMR-Magnetsystem 27 steht. Die Kühlverluste in den Kühlleitungen zum HF-Resonator 9 werden dadurch erheblich verringert. Das Ventil 16 im Gehäuse 1 sowie das Ventil 25 im Verzweigungsbereich 24 der T-förmigen Transferleitung 23 dienen der Einstellung der He-Massenflüsse bei ca. 34 K zum Vorverstärker 10 und zum LN₂-Tank 18 des NMR-Magnetsystems 27. Selbstverständlich kann über eine derartige T-förmige Transferleitung 23 auch ein Strahlungsschild 21 gekühlt werden.

Insgesamt ergibt sich eine einfache und kostengünstige Vorrichtung, bei der durch Kühlen des LN₂-Tankes mittels des zur Kühlung des NMR-Probekopfes vorgesehenen Refrigerators ohne großen Kostenaufwand die Haltezeit von LN₂ an die des LHe angeglichen werden kann.

### Referenzliste

- [1]: http://www.jastec.org/eg/product/chisso/chisso.html
- [2]: http://www.j-thermal.co.jp/jnrs-400.html
- [3]: http://www.oxinst.com/SCNNWP723.htm
- [4]: http://www.bruker-biospin.com/nmr/products/crp_platform.html
- [5]: http://www.varianinc.com/cgi-bin/nav?products/nmr/probes/liquids/cold_-probes/cold_system&cid=OHQOMQKFN

### Bezugszeichenliste

- 1: Gehäuse
- 2: Refrigerator
- 3: Erste Stufe des Refrigerators
- 4: Zweite Stufe des Refrigerators
- 5: Stufentauscher der ersten Stufe des Refrigerators
- 6: Stufentauscher der zweiten Stufe des Refrigerators
- 7: Erster Gegenstromtauscher
- 8: Zweiter Gegenstromtauscher
- 9: HF-Resonator
- 10: Vorverstärker
- 11: NMR- Probenkopf
- 12: Kompressor
- 13: Transferleitung zum HF-Resonator
- 14: Transferleitung zum Vorverstärker
- 15: Ventil
- 16: Ventil
- 17: Transferleitung zum NMR-Magnetsystem
- 18: LN₂-Tank
- 19: Wärmetauscher des LN2-Tankes
- 20: Ventil
- 21: Strahlungsschild
- 22: Wärmetauscher des Strahlungsschildes
- 23: T-förmige Transferleitung
- 24: Verzweigungsbereich der T-förmigen Transferleitung
- 25: Ventil
- 26: gemeinsamer Abschnitt der Transferleitung
- 27: NMR-Magnetsystem

## Patentansprüche

1. NMR-Spektrometer mit einem im Heliumtank eines Kryostaten angeordneten NMR-Magnetsystem (27) und mit einem in einer Raumtemperaturbohrung des Kryostaten angeordneten NMR-Probenkopf (11), der einen gekühlten HF-Resonator (9) zum Empfang von NMR-Signalen aus einer zu untersuchenden Probe und einen gekühlten Vorverstärker (10) enthält, wobei der NMR-Probenkopf (11) durch einen gemeinsamen mehrstufigen, Kompressor-betriebenen Refrigerator (2) gekühlt wird, wobei der Refrigerator (2) einen Kaltkopf und mehrere Wärmetauscher (5, 6) auf unterschiedlichen Temperaturniveaus umfasst, wobei der Refrigerator (2) im räumlichen Abstand zum Kryostaten in einem separaten, evakuierten und wärmeisolierten Gehäuse (1) angeordnet ist und mindestens ein Kühlmittelkreislauf mit durch eine Transferleitung (13, 14) thermisch isolierten Kühlmittelleitungen zwischen dem die Wärmetauscher (5, 6) enthaltenen Gehäuse (1) und dem NMR-Probenkopf (11) vorgesehen ist,
**dadurch gekennzeichnet,**
**dass** zusätzliche Kühlmittelleitungen zu einem im Kryostaten angeordneten den Heliumtank umgebenden LN₂-Tank (18) oder Strahlungsschild (21) vorgesehen sind und der Refrigerator (2) auch den LN₂-Tank (18) bzw. den Strahlungsschild (21) kühlt.

2. NMR-Spektrometer nach Anspruch 1, **dadurch gekennzeichnet, dass** der Refrigerator (2) nur den LN₂-Tank (18) bzw. den Strahlungsschild (21) und nicht den Heliumtank im Kryostaten kühlt.

3. NMR-Spektrometer nach einem der Ansprüche 1 oder 2, **dadurch gekennzeichnet, dass** die Kühlmittelleitungen, die zum HF-Resonator (9), zum Vorverstärker (10) und zum NMR-Magnetsystem (27) führen, einen gemeinsamen thermisch isolierten Abschnitt (26) innerhalb einer Transferleitung besitzen, der mindestens 50%, vorzugsweise etwa 90%, der Gesamtlänge der Transferleitungen (13, 14, 17) umfasst.

4. NMR-Spektrometer nach Anspruch 3, **dadurch gekennzeichnet, dass** innerhalb des gemeinsamen thermisch isolierten Abschnittes (26) die Kühlleitungen, die sich auf dem niedrigsten Energieniveau befinden, von mindestens einem Strahlungsschild auf einem höheren Energieniveau thermisch abgeschirmt werden.

5. NMR-Spektrometer nach einem der vorhergehenden Ansprüche, **dadurch gekennzeichnet, dass** die Transferleitungen (13, 14, 17) schwingungsdämpfende Bauteile zur Entkopplung von Refrigerator (2) und NMR-Probenkopf (11) beziehungsweise von Refrigerator (2) und Kryostat aufweisen.

6. NMR-Spektrometer nach einem der vorhergehenden Ansprüche, **dadurch gekennzeichnet, dass** zwischen dem Gehäuse (1) und dem Kryostaten ein Kühlmittelkreislauf vorgesehen ist, dessen Rücklauf sich auf einem Temperaturniveau von etwa 77K befindet.

7. NMR-Spektrometer nach einem der vorhergehenden Ansprüche, **dadurch gekennzeichnet, dass** zwischen dem Gehäuse (1) und dem NMR-Probenkopf (11) zwei Kühlmittelkreisläufe vorgesehen sind, von denen ein Kühlmittelkreislauf eine Rücklauftemperatur von etwa 77K besitzt und vorzugsweise eine Vorverstärkerelektronik im NMR-Probenkopf (11) kühlt.

8. NMR-Spektrometer nach einem der vorhergehenden Ansprüche, **dadurch gekennzeichnet, dass** zwischen dem Gehäuse (1), dem Kryostaten und dem NMR-Probenkopf (11) ein gemeinsamer Kühlmittelkreislauf vorgesehen ist, dessen Rücklauftemperatur bei etwa 77K liegt und der im NMR-Probenkopf (11) vorzugsweise eine Vorverstärkerelektronik und im Kryostaten einen LN₂-Tank (18) oder einen Strahlungsschild (21) kühlt.

9. NMR-Spektrometer nach einem der Ansprüche 6 bis 8, **dadurch gekennzeichnet, dass** die Kühlmittelkreisläufe, deren Rücklauftemperatur bei etwa 77K liegt, mit gasförmigem Helium als Kältemittel betrieben werden.

10. NMR-Spektrometer nach einem der vorhergehenden Ansprüche, **dadurch gekennzeichnet, dass** sich einer der Kühlmittelkreisläufe zwischen dem Gehäuse (1) und dem NMR-Probenkopf (11) befindet, eine Rücklauftemperatur von etwa 15K besitzt und mit gasförmigem Helium als Kühlmittel betrieben wird.

11. NMR-Spektrometer nach einem der vorhergehenden Ansprüche, **dadurch gekennzeichnet, dass** der gemeinsame Refrigerator (2) mindestens einen Stufentauscher (5, 6) aufweist, an dem mindestens ein Kältemittel entlang geführt wird, so dass dieses Kältemittel auf eine definierte Temperatur vorgekühlt wird.

12. NMR-Spektrometer nach einem der vorhergehenden Ansprüche, **dadurch gekennzeichnet, dass** der gemeinsame Refrigerator (2) ein Gifford-McMahon-Kühler oder ein Pulsrohrkühler ist.

13. NMR-Spektrometer nach einem der vorhergehenden Ansprüche, **dadurch gekennzeichnet, dass** der Kompressor (12) des Refrigerators (2) zusätzlich mindestens einen der Kühlmittelkreisläufe antreibt.

14. NMR-Spektrometer nach einem der vorhergehenden Ansprüche, **dadurch gekennzeichnet, dass** der einen LN₂-Tank (18) oder einen Strahlungsschild kühlende Kühlmittelkreislauf ein Ventil (20, 25) zur Regelung des Kühlmittelflusses und einen Wärmetauscher (19) im thermischen Kontakt mit dem LN₂.Tank (18) bzw. Strahlungsschild (21) aufweist.

15. NMR-Spektrometer nach einem der vorhergehenden Ansprüche, **dadurch gekennzeichnet, dass** die Kühlmittelkreisläufe einen Heliumkreislauf mit mindestens einer Verzweigung im Vor- und/oder Rücklauf bilden.

## Claims

1. NMR spectrometer comprising an NMR magnet system (27) disposed in a helium tank of a cryostat, and an NMR probe head (11) disposed in a room temperature bore of the cryostat, and containing a cooled RF resonator (9) for receiving NMR signals from a sample to be investigated, and a cooled pre-amplifier (10), wherein the NMR probe head (11) is cooled by a common multi-stage compressor-operated refrigerator (2), wherein the refrigerator (2) comprises a cold head and several heat exchangers (5, 6) at different temperature levels, wherein the refrigerator (2) is disposed at a spatial separation from the cryostat in a separate, evacuated and thermally insulated housing (1), and wherein at least one coolant circuit with coolant lines, which are thermally insulated by a transfer line (13, 14), is disposed between the housing (1) containing the heat exchangers (5, 6) and the NMR probe head (11), **characterized in that** additional coolant lines to an LN₂ tank (18) or radiation shield (21) disposed in the cryostat and surrounding the helium tank are provided, and the refrigerator (2) also cools the LN₂ tank (18) or the radiation shield (21).

2. NMR spectrometer according to claim 1, **characterized in that** the refrigerator (2) only cools the LN₂ tank (18) or the radiation shield (21) and not the helium tank in the cryostat.

3. NMR spectrometer according to any one of the claims 1 or 2, **characterized in that** the coolant lines leading to the RF resonator (9), to the pre-amplifier (10) and to the NMR magnet system (27) have a common thermally insulated section (26) within a transfer line which comprises at least 50%, preferably approximately 90%, of the overall length of the transfer lines (13, 14, 17).

4. NMR spectrometer according to claim 3, **characterized in that** the cooling lines with the lowest energy level are thermally shielded by at least one radiation shield of a higher energy level within the common thermally insulated section (26).

5. NMR spectrometer according to any one of the preceding claims, **characterized in that** the transfer lines (13, 14, 17) comprise vibration-damping components for decoupling the refrigerator (2) from the NMR probe head (11) or cryostat.

6. NMR spectrometer according to any one of the preceding claims, **characterized in that** a coolant circuit is provided between the housing (1) and the cryostat whose return path is at a temperature level of approximately 77 K.

7. NMR spectrometer according to any one of the preceding claims, **characterized in that** two coolant circuits are provided between the housing (1) and the NMR probe head (11), wherein one coolant circuit thereof has a return path temperature of approximately 77K and preferably cools a preamplifying electronics in the NMR probe head (11).

8. NMR spectrometer according to any one of the preceding claims, **characterized in that** a common coolant circuit is provided between the housing (1), the cryostat and the NMR probe head (11) whose return path temperature is at approximately 77 K and which preferably cools a preamplifying electronics in the NMR probe head (11), and an LN₂ tank (18) or a radiation shield (21) in the cryostat.

9. NMR spectrometer according to any one of the claims 6 through 8, **characterized in that** the coolant circuits with a return path temperature of approximately 77K are operated with gaseous helium as coolant.

10. NMR spectrometer according to any one of the preceding claims, **characterized in that** one of the coolant circuits is located between the housing (1) and the NMR probe head (11), has a return path temperature of approximately 15K and is operated with gaseous helium as coolant.

11. NMR spectrometer according to any one of the preceding claims, **characterized in that** the common refrigerator (2) comprises at least one stage exchanger (5, 6) along which at least one coolant is guided to precool this coolant to a defined temperature.

12. NMR spectrometer according to any one of the preceding claims, **characterized in that** the common refrigerator (2) is a Gifford-McMahon cooler or a pulse tube cooler.

13. NMR spectrometer according to any one of the preceding claims, **characterized in that** the compressor (12) of the refrigerator (2) additionally drives at least one of the coolant circuits.

14. NMR spectrometer according to any one of the preceding claims, **characterized in that** the coolant circuit cooling an LN₂ tank (18) or a radiation shield comprises a valve (20, 25) for regulating the coolant flow and a heat exchanger (19) which is in thermal contact with the LN₂ tank (18) or radiation shield (21).

15. NMR spectrometer according to any one of the preceding claims, **characterized in that** the coolant circuits form a helium circuit with at least one branch in the forward and/or return path.

## Revendications

1. Spectromètre à RMN avec un système d'aimant RMN (27) disposé dans le réservoir d'hélium d'un cryostat et avec une tête de mesure RMN (11) disposée dans un alésage à température ambiante du cryostat, laquelle contient un résonateur HF (9) refroidi pour la réception de signaux RMN provenant d'un échantillon à analyser et un préamplificateur (10) refroidi, la tête de mesure RMN (11) étant refroidie par un réfrigérateur (2) commun à plusieurs étages actionné par compresseur, le réfrigérateur (2) comprenant une tête froide et plusieurs échangeurs thermiques (5, 6) à différents niveaux de température, le réfrigérateur (2) étant disposé à distance spatiale du cryostat dans un boîtier (1) séparé, évacué et isolé à la chaleur et au moins un circuit de réfrigérant avec des canalisations de réfrigérant thermiquement isolées par une canalisation de transfert (13, 14) étant prévu entre le boîtier (1) contenant les échangeurs thermiques (5, 6) et la tête de mesure RMN (11),
**caractérisé par le fait**
**qu'**il est prévu des canalisations de réfrigérant supplémentaires vers un réservoir de LN₂ (18) disposé dans le cryostat, entourant le réservoir d'hélium, et que le réfrigérateur (2) refroidit aussi le réservoir de LN₂ (18) ou l'écran anti-rayonnement (21).

2. Spectromètre à RMN selon la revendication 1, **caractérisé par le fait que** le réfrigérateur (2) ne refroidit que le réservoir de LN₂ (18) ou l'écran anti-rayonnement (21) et pas le réservoir d'hélium dans le cryostat.

3. Spectromètre à RMN selon l'une des revendications 1 ou 2, **caractérisé par le fait que** les canalisations de réfrigérant qui mènent au résonateur HF (9), au préamplificateur (10) et au système d'aimant RMN (27) possèdent une section commune (26) thermiquement isolée à l'intérieur d'une canalisation de transfert, qui comprend au moins 50 %, de préférence environ 90 % de la longueur totale des canalisations de transfert (13, 14, 17).

4. Spectromètre à RMN selon la revendication 3, **caractérisé par le fait qu'**à l'intérieur de la section commune (26) thermiquement isolée, les canalisations de réfrigérant qui se trouvent au niveau énergétique le plus bas sont écrantées thermiquement par au moins un écran anti-rayonnement à un niveau énergétique plus élevé.

5. Spectromètre à RMN selon l'une des revendications précédentes, **caractérisé par le fait que** les canalisations de transfert (13, 14, 17) présentent des composants amortisseurs de vibrations pour le découplage du réfrigérateur (2) et de la tête de mesure RMN (11), respectivement du réfrigérateur (2) et du cryostat.

6. Spectromètre à RMN selon l'une des revendications précédentes, **caractérisé par le fait qu'**il est prévu entre le boîtier (1) et le cryostat un circuit de réfrigérant dont le retour se trouve à un niveau de température d'environ 77 K.

7. Spectromètre à RMN selon l'une des revendications précédentes, **caractérisé par le fait qu'**il est prévu entre le boîtier (1) et la tête de mesure RMN (11) deux circuits de réfrigérant dont un circuit de réfrigérant possède une température de retour d'environ 77 K et refroidit de préférence une électronique de préamplificateur dans la tête de mesure RMN (11).

8. Spectromètre à RMN selon l'une des revendications précédentes, **caractérisé par le fait qu'**il est prévu entre le boîtier (1), le cryostat et la tête de mesure RMN (11) un circuit de réfrigérant commun dont la température de retour est d'environ 77 K et qui refroidit de préférence une électronique de préamplificateur dans la tête de mesure RMN (11) et un réservoir de LN₂ (18) ou un écran anti-rayonnement (21) dans le cryostat.

9. Spectromètre à RMN selon l'une des revendications 6 à 8, **caractérisé par le fait que** les circuits de réfrigérant dont la température de retour est d'environ 77 K fonctionnent avec de l'hélium gazeux en tant que fluide réfrigérant.

10. Spectromètre à RMN selon l'une des revendications précédentes, **caractérisé par le fait qu'**un des circuits de réfrigérant se trouve entre le boîtier (1) et la tête de mesure RMN (11), possède une température de retour d'environ 15 K et fonctionne avec de l'hélium gazeux en tant que fluide réfrigérant.

11. Spectromètre à RMN selon l'une des revendications précédentes, **caractérisé par le fait que** le réfrigérateur (2) commun présente au moins un échangeur étagé (5, 6) le long duquel est conduit au moins un fluide réfrigérant de manière que ce fluide réfrigérant soit prérefroidi à une température définie.

12. Spectromètre à RMN selon l'une des revendications précédentes, **caractérisé par le fait que** le réfrigérateur (2) commun est un réfrigérateur Gifford-McMahon ou un réfrigérateur à tube pulsé.

13. Spectromètre à RMN selon l'une des revendications précédentes, **caractérisé par le fait que** le compresseur (12) du réfrigérateur (2) actionne en plus au moins un des circuits de réfrigérant.

14. Spectromètre à RMN selon l'une des revendications précédentes, **caractérisé par le fait que** le circuit de réfrigérant refroidissant un réservoir de LN₂ (18) ou un écran anti-rayonnement présente une vanne (20, 25) pour réguler le flux de réfrigérant et un échangeur thermique (19) en contact thermique avec le réservoir de LN₂ (18) ou l'écran anti-rayonnement (21).

15. Spectromètre à RMN selon l'une des revendications précédentes, **caractérisé par le fait que** les circuits de réfrigérant forment un circuit d'hélium avec au moins un embranchement dans le départ et/ou le retour.
